(19) **Europäisches Patentamt / European Patent Office / Office européen des brevets**

(11) **EP 4 734 149 A1**

(12) **EUROPEAN PATENT APPLICATION**
published in accordance with Art. 153(4) EPC

(43) Date of publication:
**29.04.2026 Bulletin 2026/18**

(21) Application number: **24826002.8**

(22) Date of filing: **21.06.2024**

(51) International Patent Classification (IPC):
**H01J 37/28** (2006.01)     **G01N 23/04** (2018.01)

(52) Cooperative Patent Classification (CPC):
**G01N 23/04; H01J 37/28**

(86) International application number:
**PCT/JP2024/022523**

(87) International publication number:
**WO 2024/262601 (26.12.2024 Gazette 2024/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.06.2023 JP 2023101824**

(71) Applicant: **The University of Tokyo**
**Bunkyo-ku**
**Tokyo 113-8654 (JP)**

(72) Inventors:
- **SEKI Takehito**
  **Tokyo 113-8654 (JP)**
- **SHIBATA Naoya**
  **Tokyo 113-8654 (JP)**
- **NOGAMI Mitsuru**
  **Tokyo 113-8654 (JP)**
- **OOE Kousuke**
  **Tokyo 113-8654 (JP)**
- **IKUHARA Yuichi**
  **Tokyo 113-8654 (JP)**

(74) Representative: **Bandpay & Greuter**
**11, rue Christophe Colomb**
**75008 Paris (FR)**

(54) **MEASUREMENT METHOD USING SCANNING TRANSMISSION ELECTRON MICROSCOPE, SCANNING TRANSMISSION ELECTRON MICROSCOPE SYSTEM, AND PROGRAM**

(57)     A scanning transmission electron microscope system (100) includes: an irradiation source (102) configured to generate an electron beam (EB); a lens (104) configured to converge the electron beam (EB) onto a sample (S); a detector (106) configured to detect the electron beam (EB) transmitted through the sample (S), and acquire a detection signal which is a four-dimensional dataset represented by a two-dimensional scanning position on the sample (S) and two-dimensional coordinates on a detector plane; and a computer (108) configured to perform a Fourier transform on the detection signal acquired by the detector (106) with respect to the scanning position to obtain Fourier transform data of a complex number represented by a two-dimensional spatial frequency and the two-dimensional coordinates, calculate, for a specific spatial frequency, a thickness of the sample (S) and an inclination of the sample (S) with respect to a predetermined direction from an amplitude of the Fourier transform data, and calculate, for a specific spatial frequency, an aberration of the lens (104) from a phase of the Fourier transform data.

Fig. 1

## Description

Technical Field

The present invention relates to a measurement method using a scanning transmission electron microscope, a scanning transmission electron microscope system, and a program.

Background Art

Scanning transmission electron microscopy (STEM) is known as a method for observing an atomic structure inside substances. STEM is a method of scanning a sample with finely converged electron beams (probe), detecting electrons transmitted from each point of the sample by a detector, and observing an atomic structure in the sample. Meanwhile, a sample having low resistance to an electron beam causes serious damage during observation. In order to prevent such damage of the sample, it is preferable to perform observation under a low electron dose condition with less irradiation damage. However, under a low electron dose condition, there is a problem that a signal-to-noise ratio (SN ratio) of an obtained image decreases.

Against such a background, an optimum bright field (OBF) method was developed as an imaging technique that enables highly sensitive observation even under a low electron dose conditions (for example, see Patent Literature 1 and Non-Patent Literature 1). In the OBF method, a segmented detector or a pixelated detector is used as a detector, and a sample image is reconstructed from a dataset acquired by the detector such that a theoretical SN ratio is maximized. By using the OBF method, the atomic structure of the sample can be clearly visualized even under a low electron dose condition as compared with a conventional method.

Citation List

Patent Literature

Patent Literature 1: WO 2021/090528

Non-Patent Literature

Non-Patent Literature 1: Kousuke Ooe, Takehito Seki, Yuichi Ikuhara, and Naoya Shibata, "Ultra-high contrast STEM imaging for segmented/pixelated detectors by maximizing the signal-to-noise ratio," Ultramicroscopy 220, 113133 (2021).

Summary of Invention

Technical Problem

In the OBF method, a sample image is usually calculated by assuming ideal observation conditions. Here, the observation conditions refer to parameters required for observing the sample using a scanning transmission electron microscope, such as a thickness of the sample, an inclination of a crystalline orientation of the sample from an optical axis, and a distortion (aberration) of an optical system. In a reconstruction process of the sample image by the OBF method, usually, an approximate value is used for the thickness of the sample and it is assumed that other parameters are sufficiently corrected. Meanwhile, in observation of a sample made of an electron beam sensitive material, parameters of observation conditions may be unknown, for example, the thickness may vary depending on the scanning position, or it may be difficult to precisely adjust the crystalline orientation of the sample and the aberration of the optical system. If the observation condition deviates from the ideal observation condition, an optimum sample image cannot be obtained.

The present invention has been made in view of the above problems, and an object thereof is to provide a measurement method using a scanning transmission electron microscope, a scanning transmission electron microscope system, and a program capable of estimating an observation condition of a sample from data acquired by a detector of the scanning transmission electron microscope.

Solution to Problem

A measurement method using a scanning transmission electron microscope according to an embodiment of the present invention is a measurement method of an observation condition of a sample using a scanning transmission electron microscope, the measurement method including: generating an electron beam by an irradiation source;

converging the electron beam generated by the irradiation source onto the sample by an optical system; detecting, by a detector, the electron beam transmitted through the sample, and acquiring a detection signal which is a four-dimensional dataset represented by a two-dimensional scanning position on the sample and two-dimensional coordinates on a detector plane; and causing a computer to perform a Fourier transform on the detection signal acquired by the detector with respect to the scanning position to obtain Fourier transform data of a complex number represented by a two-dimensional spatial frequency and the two-dimensional coordinates, and calculate, for a specific spatial frequency, a thickness of the sample and an inclination of the sample with respect to a predetermined direction from an amplitude of the Fourier transform data when the sample is a crystalline sample; and calculate, for a specific spatial frequency, an aberration of the optical system from a phase of the Fourier transform data when the sample is a crystalline sample or an amorphous sample.

A scanning transmission electron microscope system according to an embodiment of the present invention is a scanning transmission electron microscope system for measuring an observation condition of a sample, the scanning transmission electron microscope system including: an irradiation source configured to generate an electron beam; an optical system configured to converge the electron beam generated by the irradiation source onto the sample; a detector configured to detect the electron beam transmitted through the sample, and acquire a detection signal which is a four-dimensional dataset represented by a two-dimensional scanning position on the sample and two-dimensional coordinates on a detector plane; and a computer configured to perform a Fourier transform on the detection signal acquired by the detector with respect to the scanning position to obtain Fourier transform data of a complex number represented by a two-dimensional spatial frequency and the two-dimensional coordinates, calculate, for a specific spatial frequency, a thickness of the sample and an inclination of the sample with respect to a predetermined direction from an amplitude of the Fourier transform data when the sample is a crystalline sample; and calculate, for a specific spatial frequency, an aberration of the optical system from a phase of the Fourier transform data when the sample is a crystalline sample or an amorphous sample.

A program according to an embodiment of the present invention is a program for estimating an observation condition of a sample using a scanning transmission electron microscope, the program causing a computer to execute: acquiring, from a detector that detects an electron beam transmitted through the sample, a detection signal which is a four-dimensional dataset represented by a two-dimensional scanning position on the sample and two-dimensional coordinates on a detector plane, and performing a Fourier transform on the detection signal with respect to the scanning position to obtain Fourier transform data of a complex number represented by a two-dimensional spatial frequency and the two-dimensional coordinates; and calculating, for a specific spatial frequency, a thickness of the sample and an inclination of the sample with respect to a predetermined direction from an amplitude of the Fourier transform data when the sample is a crystalline sample; and calculating, for a specific spatial frequency, an aberration of an optical system of the scanning transmission electron microscope from a phase of the Fourier transform data when the sample is a crystalline sample or an amorphous sample.

Advantageous Effects of Invention

According to the present invention, by performing a Fourier transform on the detection signal acquired by the detector and calculating the amplitude and phase, sample observation conditions such as the thickness of the sample, the inclination of the sample, and the aberration of the optical system can be estimated.

Brief Description of Drawings

Fig. 1 is a schematic diagram illustrating a main configuration of a scanning transmission electron microscope system according to the present embodiment.
Fig. 2 is a block diagram illustrating a configuration of a computer that executes an observation condition estimation method.
Fig. 3 is a schematic diagram illustrating a four-dimensional dataset acquired by a detector.
Fig. 4 is a schematic diagram illustrating a lens transfer function.
Fig. 5 is a schematic diagram illustrating double overlap regions where two disks represented by lens transfer functions overlap.
Fig. 6 is a diagram illustrating examples of an amplitude of Fourier transform data obtained when the sample is thin and thick, respectively.
Fig. 7 is a diagram illustrating examples of the amplitude of the Fourier transform data obtained when the sample is not inclined and when the sample is inclined, respectively.
Fig. 8 is a diagram illustrating examples of a phase of the Fourier transform data obtained when an aberration of an optical system is absent and when the aberration is present, respectively.

Fig. 9 is a schematic diagram illustrating a derivation process of the lens transfer function when a thickness of the sample is taken into consideration.

Fig. 10 is a schematic diagram illustrating the inclination of the sample and an inclination of an optical axis of an electron beam.

Fig. 11 is a schematic diagram illustrating a parallel movement of a center of an aperture function when the optical axis of the electron beam is inclined.

Fig. 12 is a schematic diagram illustrating the amplitude of the Fourier transform data.

Fig. 13 is a graph illustrating examples of a profile of the amplitude of the Fourier transform data.

Fig. 14 is a schematic diagram illustrating the phase of the Fourier transform data.

Fig. 15 is a schematic diagram illustrating a triple overlap region where three disks represented by the lens transfer function overlap.

Fig. 16 is a diagram illustrating examples of simulation results of the Fourier transform data obtained when the aberration of the optical system is absent and when the aberration is present at the time of observing an amorphous sample, respectively.

Fig. 17 is a schematic diagram illustrating a method for estimating the aberration of the optical system using the amorphous sample.

Description of Embodiments

Embodiments of the present invention will be described below with reference to the drawings. The same or similar components are denoted by the same reference numerals throughout the drawings. The drawings are schematic, and a correlation between a plane dimension and a thickness and a ratio of the thicknesses of the members are different from actual ones. As a matter of course, those having portions having different dimensional correlations and ratios between the drawings are included as well.

<System Configuration>

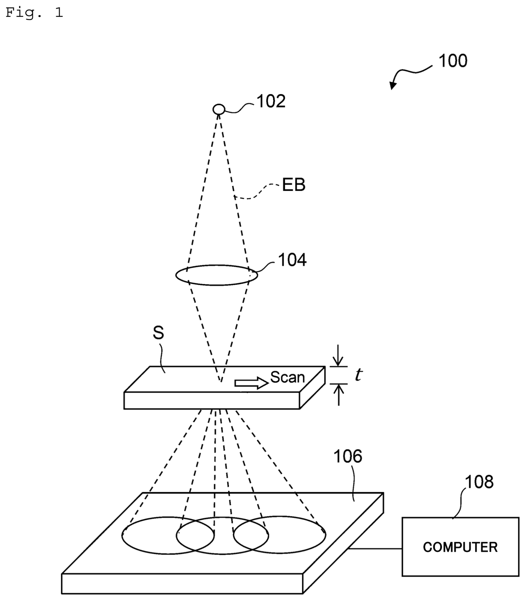

First, a system configuration of the present embodiment will be described. Fig. 1 illustrates a main configuration of a scanning transmission electron microscope system 100 according to the present embodiment. As illustrated in Fig. 1, the scanning transmission electron microscope system 100 includes an irradiation source 102, a lens 104, a detector 106, and a computer 108.

The irradiation source 102 has an electron gun, and generates electron beams EB by accelerating electrons emitted from a cathode with an anode.

The lens 104 is an optical system disposed on a downstream side of the irradiation source 102, and converges the electron beams EB generated by the irradiation source 102 onto a sample S held in a sample holder.

The electron beams EB scan the sample S two-dimensionally such that a part of irradiation regions overlap, and the detector 106 detects the electron beams EB transmitted through the sample S. A pixelated detector can be used as the detector 106. The pixelated detector detects the electron beams EB transmitted through the sample S by a two-dimensional image sensor, and records a convergent-beam electron diffraction (CBED) pattern at each scanning position (for each pixel). The detector 106 is connected to the computer 108, and a signal detected by the detector 106 is output to the computer 108.

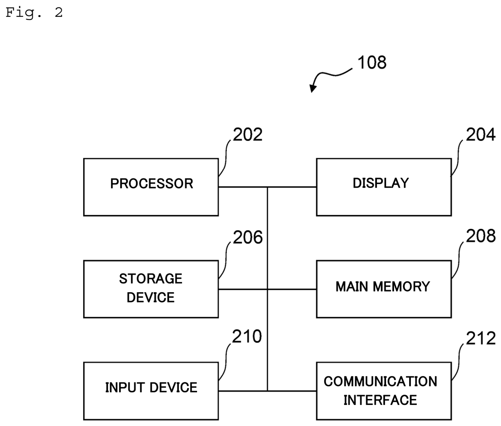

As illustrated in Fig. 2, the computer 108 includes a processor 202, a display 204, a storage device 206, a main memory 208, an input device 210, and a communication interface 212, and these devices are connected to each other via a bus.

The processor 202 has a central processing unit (CPU), and acquires a detection signal from the detector 106 in accordance with a program stored in the storage device 206, and executes an observation condition estimation method, which will be described later.

The display 204 is a display such as a liquid crystal display (LCD), a plasma display, or an organic electroluminescence (EL) display, and displays a result of the execution by the processor 202.

The storage device 206 is a non-volatile memory, and stores various programs executed by the processor 202 and data necessary for executing these programs.

The main memory 208 is a volatile memory. The programs and data stored in the storage device 206 are loaded into the main memory 208 and executed.

The programs executed by the processor 202 and the data necessary for executing these programs may be recorded in a nontransitory computer-readable recording medium (for example, a memory card) that is detachable from the computer 108, or may be received from a network via the communication interface 212.

The input device 210 is an input device such as a keyboard, a mouse, or a touch panel, and receives an operation input from a user.

The communication interface 212 is an interface for transmitting and receiving data to and from an external device via a network such as a local area network (LAN), a wide area network (WAN), or the Internet.

Instead of general-purpose hardware such as a CPU, the processor 202 may be dedicated hardware such as an application specific integrated circuit (ASIC) or a field programmable gate array (FPGA) that is specialized for implementing the observation condition estimation method according to the present embodiment.

<Measurement Method Using Scanning Transmission Electron Microscope>

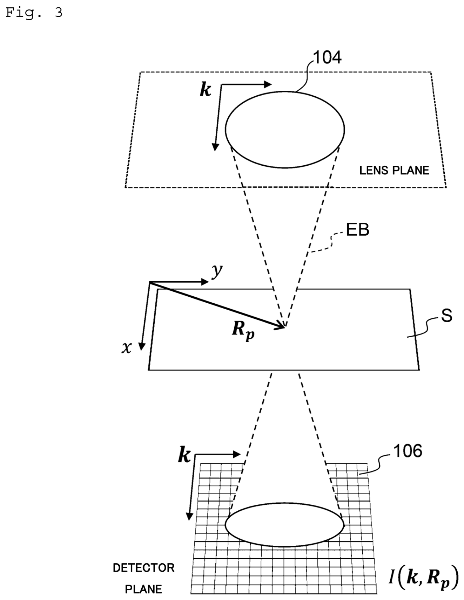

Next, a measurement method using the scanning transmission electron microscope according to the present embodiment will be described with reference to Figs. 3 to 17.

As illustrated in Fig. 3, the signal detected by the detector 106 is an intensity $I(k, R_p)$ of a diffraction pattern of the electron beam EB. Here, k is a coordinate $(k_x, k_y)$ on a detector plane, and $R_p$ is a scanning position (x, y) on the sample S. In this way, the detector 106 acquires a four-dimensional dataset represented by the two-dimensional coordinate k on the detector plane and the two-dimensional scanning position $R_p$.

By performing a Fourier transform on the intensity $I(k, R_p)$ with respect to the scanning position $R_p$, Fourier transform data of a complex number represented by k and a two-dimensional spatial frequency $Q_p$ is obtained. The obtained Fourier transform data is denoted by $G(k, Q_p)$ as in Equation (1).

[Math. 1]

$$G(k, Q_p) = \mathcal{F}_{R_p \to Q_p}[I(k, R_p)] \quad \cdots (1)$$

When the thickness of the sample S is t, the inclination of the sample S with respect to a predetermined direction (for example, the inclination of the crystalline orientation of the sample S from the optical axis of the electron beam EB) is $\varphi = (\varphi_x, \varphi_y)$, and the wavelength of the electron beam EB is $\lambda$, the Fourier transform data $G(k, Q_p)$ is expressed by Equation (2).

[Math. 2]

$$G(k, Q_p) = i\left[\frac{\sin(\omega_1 t)}{\omega_1 t} \cdot T^*(k)T(k - Q_p) - \frac{\sin(\omega_2 t)}{\omega_2 t} \cdot T(k)T^*(k + Q_p)\right]\sigma V(Q_p) \quad \cdots (2)$$

In Equation (2), * represents a complex conjugate. T(k) is a lens transfer function representing the characteristics of the lens 104, and $\sigma$ is an interaction constant. $V(Q_p)$ is the Fourier transform of a projection potential of the sample S, and depends on atomic species constituting the sample S, the structure thereof, and an observation direction.

$\omega_1$ and $\omega_2$ in Equation (2) are given by Equation (3) and Equation (4), respectively.

[Math. 3]

$$\omega_1 = \pi\lambda\left(k \cdot Q_p - \frac{|Q_p|^2}{2}\right) + \pi\phi \cdot Q_p \quad \cdots (3)$$

[Math. 4]

$$\omega_2 = -\pi\lambda\left(k \cdot Q_p + \frac{|Q_p|^2}{2}\right) - \pi\phi \cdot Q_p \quad \cdots (4)$$

The lens transfer function T(k) of Equation (2) is expressed by Equation (5) using the coordinate k of the lens surface as a variable. A(k) is an aperture function, and $\chi(k)$ is an aberration function representing distortion of the optical system.

[Math. 5]

$$T(k) = A(k)\exp(-i\chi(k)) \quad \cdots (5)$$

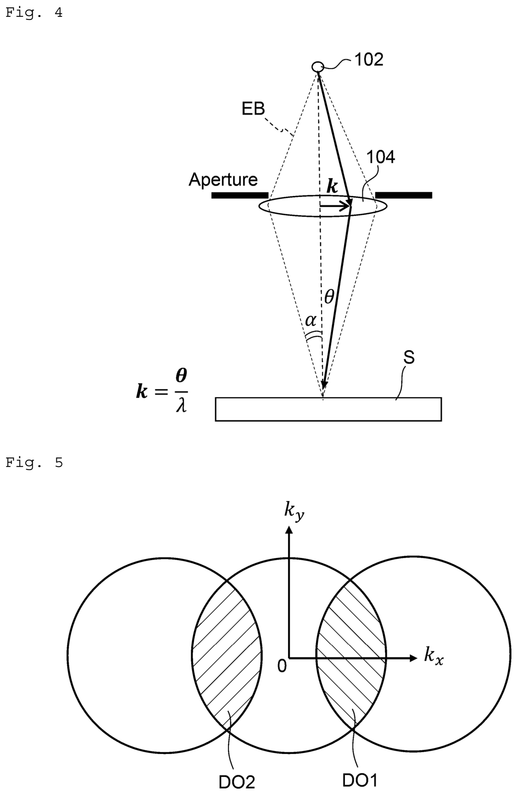

As illustrated in Fig. 4, when an incident angle of the electron beam EB on the sample S is $\theta$ and a convergence

semiangle is α, the aperture function A(k) takes a value of 1 inside the aperture and a value of 0 outside the aperture as illustrated in Equation (6).

[Math. 6]

$$A(\boldsymbol{k}) = \begin{cases} 1 & (\theta < \alpha) \\ 0 & (other) \end{cases} \quad \cdots (6)$$

When the aberration function $\chi(k)$ is expressed by the incident angle $\theta = (\theta_x, \theta_y)$ ($k = \theta/\lambda$), the aberration function $\chi$(k) is given by Equation (7), and the phase deviation due to the distortion of the optical system can be expressed by a polynomial of θ.

[Math. 7]

$$\chi(\theta_x, \theta_y) = \frac{2\pi}{\lambda}\Big\{\frac{1}{2}C_{1,0}\big(\theta_x^2 + \theta_y^2\big) + \frac{1}{2}C_{1,2a}\big(\theta_x^2 - \theta_y^2\big) + C_{1,2b}\theta_x\theta_y + \frac{1}{3}C_{2,1a}\theta_x\big(\theta_x^2 + \theta_y^2\big)$$
$$+ \frac{1}{3}C_{2,1b}\theta_y\big(\theta_x^2 + \theta_y^2\big) + \frac{1}{3}C_{2,3a}\theta_x\big(\theta_x^2 - 3\theta_y^2\big) + \frac{1}{3}C_{2,3b}\theta_y\big(3\theta_x^2 - \theta_y^2\big)$$
$$+ \frac{1}{4}C_{3,0}\big(\theta_x^2 + \theta_y^2\big)^2 + \frac{1}{4}C_{3,2a}\big(\theta_x^4 - \theta_y^4\big) + \frac{1}{2}C_{3,2b}\theta_x\theta_y\big(\theta_x^2 + \theta_y^2\big)$$
$$+ \frac{1}{4}C_{3,4a}\big(\theta_x^4 - 6\theta_x^2\theta_y^2 + \theta_y^4\big) + C_{3,4b}\big(\theta_x\theta_y^3 - \theta_x^3\theta_y\big)\Big\} \qquad \cdots (7)$$

Equation (7) is based on Equation (2.23) in Earl J. Kirkland, "Advanced Computing in Electron Microscopy," Second Edition, Springer, and includes terms up to the fourth order of θ. In addition, the meaning of each aberration coefficient $C_{n,m}$ in Equation (7) is described in the column of Krivanek of Table A. 2 of the following Non-Patent Literature. For example, $C_{1,0}$ means defocus.

H. Sawada, T. Sannomiya, F. Hosokawa, T. Nakamichi, T. Kaneyama, T. Tomita, Y. Kondo, T. Tanaka, Y. Oshima, Y. Tanishiro, and K. Takayanagi, "Measurement method of aberration from Ronchigram by autocorrelation function," Ultramicroscopy 108, 1467-1475 (2008)

Hereinafter, attention is paid to the specific spatial frequency $Q_p$ of the Fourier transform data $G(k, Q_p)$. In Equation (2), $T^*(k)T(k - Q_p)$ represents the interference between a transmission disk centered on k = 0 and a scattering disk centered on k = +$Q_p$, and $T(k)T^*(k + Q_p)$ represents the interference between the above transmission disk and a scattering disk centered on k = -$Q_p$. As illustrated in Fig. 5, a double overlap region in which two disks corresponding to $T^*(k)$ and $T(k - Q_p)$ overlap is denoted by DO1, and a double overlap region in which two disks corresponding to $T(k)$ and $T^*(k + Q_p)$ overlap is denoted by DO2.

From Equation (5) and Equation (6), $T^*(k)T(k - Q_p)$ has a value other than zero only at DO1, and $T(k)T^*(k + Q_p)$ has a value other than zero only at DO2. Therefore, in the analysis of the Fourier transform data $G(k, Q_p)$, attention is paid to the values at DO1 and DO2. Derivation of Equations (2) to (4) will be described later.

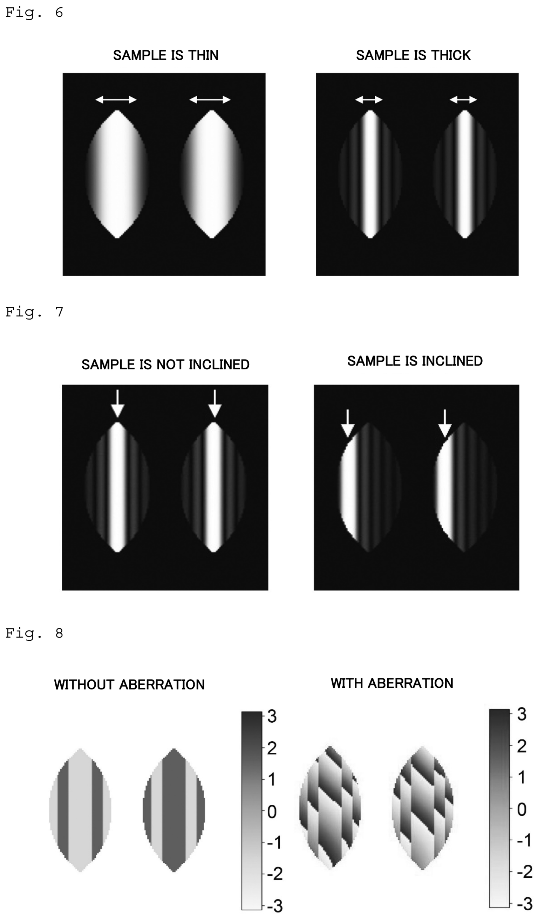

Fig. 6 illustrates examples of an amplitude (absolute value) of the Fourier transform data $G(k, Q_p)$ respectively obtained when the thickness t is relatively small and when the thickness t is relatively large for the crystalline sample S (for example, a single crystal sample). It can be seen from Fig. 6 that as the sample S becomes thicker, the peak width of the amplitude becomes narrower, and the thickness t is reflected in the peak width of the detection signal.

Fig. 7 illustrates examples of the amplitude (absolute value) of the Fourier transform data $G(k, Q_p)$ respectively obtained when the crystalline sample S is not inclined with respect to the predetermined direction and when the crystalline sample S is inclined with respect to the predetermined direction. It can be seen from Fig. 7 that the peak position of the amplitude deviates as the sample S is inclined, and the inclination of the sample S is reflected in the peak position of the detection signal.

Fig. 8 illustrates examples of the phase (argument) of the Fourier transform data $G(k, Q_p)$ respectively obtained when the aberration of the optical system (distortion of the lens 104) is absent and when the aberration is present at the time of observing the crystalline sample S. It can be seen from Fig. 8 that the presence of aberration is reflected in the phase of detection signal.

As described above, the parameters of the observation condition can be estimated by obtaining the Fourier transform data from the detection signal of the detector 106. Since the actual structure of the sample S is obtained by adding a plurality of frequency components, the detection signal acquired by the detector 106 is also obtained by adding a plurality of frequency components.

Next, the derivation process of Equations (2) to (4) will be described, and then the observation condition estimation method will be specifically described.

In weak phase object approximation (hereinafter, referred to as WPOA), which is effective when the sample S is sufficiently thin, it is assumed that the sample S is projected in an incident direction of the electron beam EB and treated two-dimensionally, and that electron propagation within the sample S is ignored. When the Fourier transform is performed on the intensity $I(k, R_p)$ with respect to the scanning position $R_p$ under WPOA, the Fourier transform data $G(k, Q_p)$ at the spatial frequency $Q_p$ is obtained as illustrated in Equation (8) (see Patent Literature 1 and Non-Patent Literature 1).
[Math. 8]

$$G\big(\boldsymbol{k}, \boldsymbol{Q}_p\big) = |T(\boldsymbol{k})|^2 \delta\big(\boldsymbol{Q}_p\big) + i\big[T^*(\boldsymbol{k})T\big(\boldsymbol{k} - \boldsymbol{Q}_p\big) - T(\boldsymbol{k})T^*\big(\boldsymbol{k} + \boldsymbol{Q}_p\big)\big]\sigma V\big(\boldsymbol{Q}_p\big) \quad \cdots(8)$$

Meanwhile, in thick WPOA (hereinafter, referred to as tWPOA), which takes the sample S with a finite thickness into consideration, it is assumed that the sample S, with a finite thickness, consists of a large number of thin slices, and each slice is a weak phase object. Under this assumption, all the detection signals acquired by the detector 106 can be considered as the sum of the detection signals independently acquired in each slice. Assuming that the position of the j-th slice along the optical axis (z-axis) of the electron beam EB is $z_j$, in the case of $Q_p \neq 0$, when $I(k, R_p)$ is subjected to the Fourier transform with respect to $R_p$ under tWPOA, the Fourier transform data $G(k, Q_p)$ illustrated in Equation (9) is obtained.
[Math. 9]

$$G\big(\boldsymbol{k}, \boldsymbol{Q}_p\big) = i \sum_j \big[T^*\big(\boldsymbol{k}, z_j\big)T\big(\boldsymbol{k} - \boldsymbol{Q}_p, z_j\big) - T\big(\boldsymbol{k}, z_j\big)T^*\big(\boldsymbol{k} + \boldsymbol{Q}_p, z_j\big)\big]\sigma V_j\big(\boldsymbol{Q}_p\big) \quad \cdots(9)$$

In Equation (9), $T(k, z_j)$ and $V_j(Q_p)$ are the lens transfer function at the position $z_j$ and the Fourier transform of the projection potential of the j-th slice, respectively. When the sample S has a periodic structure along the z axis, the sample S can be sliced such that $V_j(Q_p)$ of each slice becomes equal, and is represented by $V_j(Q_p) = V(Q_p) \cdot (1/n)$. Here, n is the number of slices.

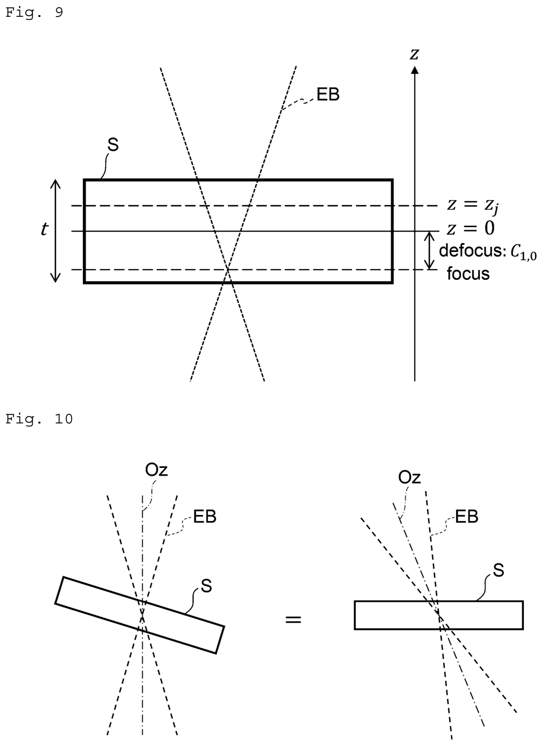

In order to derive $T(k, z_j)$ of Equation (9), first, a lens transfer function in a central plane (z = 0) of the sample S illustrated in Fig. 9 is represented as $T(\alpha) = A(\alpha)\exp(-i\chi(\alpha))$, and a lens transfer function $T(\alpha; z_j) = A(\alpha; z_j)\exp(-i\chi(\alpha; z_j))$ at a position $z = z_j$ is considered. Here, $A(\alpha; z_j)$ and $\chi(\alpha; z_j)$ are the aperture function and the aberration function of the position $z_j$, respectively. Since the aperture function does not depend on the position in the z direction, $A(\alpha; z_j) = A(\alpha)$ is established.

Meanwhile, in the aberration function, when the position in the z direction changes, the defocus value also changes. As illustrated in Fig. 9, assuming that the defocus value at z = 0 is $C_{1,0}$, the defocus value at $z = z_j$ can be considered to be $C_{1,0} + z_j$. Therefore, $\chi(\alpha; z_j) = \chi(\alpha) + (\pi/\lambda)z_j\alpha^2$ is derived from Equation (7). Therefore, $T(\alpha; z_j)$ is expressed by Equation (10).
[Math. 10]

$$T\big(\boldsymbol{\alpha}; z_j\big) = A\big(\boldsymbol{\alpha}; z_j\big) \exp\left(-i\chi\big(\boldsymbol{\alpha}; z_j\big)\right)$$

$$= A(\boldsymbol{\alpha}) \exp\left(-i\left(\chi(\boldsymbol{\alpha}) + \frac{\pi}{\lambda}z_j\alpha^2\right)\right)$$

$$= A(\boldsymbol{\alpha}) \exp\left(-i\chi(\boldsymbol{\alpha})\right) \exp\left(-i\frac{\pi}{\lambda}z_j\alpha^2\right)$$

$$= T(\boldsymbol{\alpha}) \exp\left(-i\frac{\pi}{\lambda}z_j\alpha^2\right) \qquad \cdots(10)$$

Since $\alpha = \lambda k$, $T(k, z_j)$ is derived as in Equation (11).
[Math. 11]

$$T\big(\boldsymbol{k}, z_j\big) = T(\boldsymbol{k}) \exp\big(-i\pi\lambda|\boldsymbol{k}|^2 z_j\big) \quad \cdots(11)$$

Assuming that each slice of the sample S is sufficiently thin, the sum in Equation (9) can be considered as integration from -t/2 to t/2 for z as in Equation (12). Equation (2) can be derived by calculating the integration in Equation (12).
[Math. 12]

$$G(\boldsymbol{k},\boldsymbol{Q_p}) = \frac{i}{t}\int_{-\frac{t}{2}}^{\frac{t}{2}}\left[T^*(\boldsymbol{k},z)T(\boldsymbol{k}-\boldsymbol{Q_p},z)-T(\boldsymbol{k},z)T^*(\boldsymbol{k}+\boldsymbol{Q_p},z)\right]\sigma V(\boldsymbol{Q_p})dz \quad \cdots(12)$$

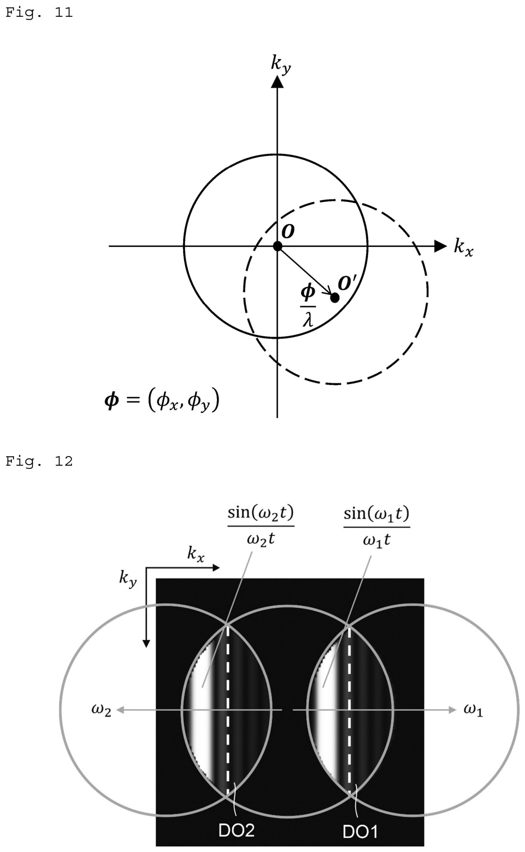

Next, the influence of the inclination of the sample S will be considered. As illustrated in Fig. 10, in obtaining the amplitude (absolute value) of G(k, $Q_p$), the inclination of the sample S can be regarded as equivalent to the inclination of the incident electrons (inclination of the optical axis Oz of the electron beam EB). When the inclination of the sample S is regarded as the inclination of the incident electrons and the inclination of the incident electrons is $\varphi = (\varphi_x, \varphi_y)$, as illustrated in Fig. 11, the center O = (0, 0) of the aperture function deviates to O' = $(\varphi_x/\lambda, \varphi_y/\lambda)$, and the aperture function can be considered to move in parallel.

At this time, the absolute value of G(k, $Q_p$) appears to move in parallel by $(\varphi_x/\lambda, \varphi_y/\lambda)$ on the k = $(k_x, k_y)$ plane. Therefore, the absolute value distribution of G(k, $Q_p$) appears to move by $\pi\varphi \cdot Q_p$ on the $\omega_1 = \pi\lambda(k \cdot Q_p - |Q_p|^2/2)$ axis, and appears to move by $-\pi\varphi \cdot Q_p$ on the $\omega_2 = -\pi\lambda(k \cdot Q_p + |Q_p|^2/2)$ axis. As a result, Equation (3) and Equation (4) can be derived.

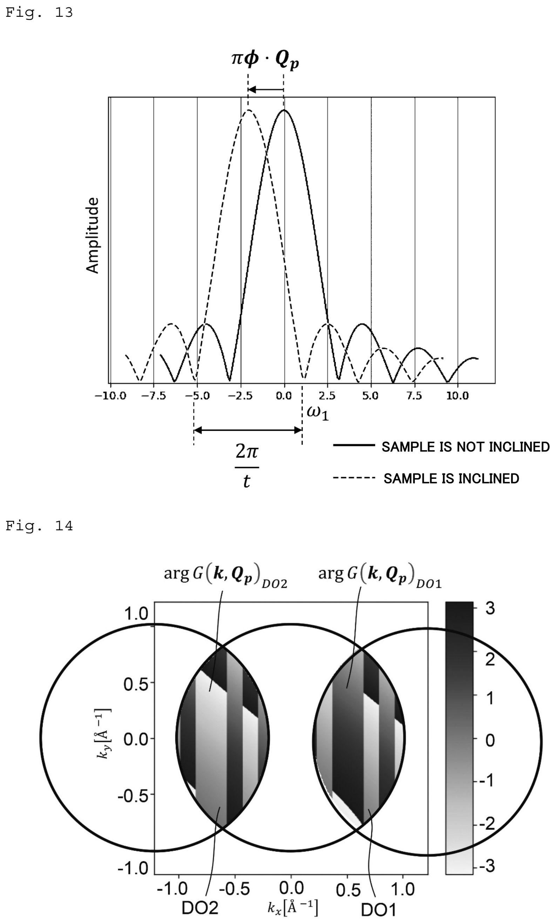

As illustrated in Fig. 12, the amplitude of G(k, $Q_p$) at DO1 is proportional to the absolute value of sinc($\omega_1$t) = sin($\omega_1$t)/$\omega_1$t, and the amplitude of G(k, $Q_p$) at DO2 is proportional to the absolute value of sinc ($\omega_2$t) = sin($\omega_2$t)/$\omega_2$t. Fig. 13 illustrates examples of the absolute value distribution profile of G(k, $Q_p$) in the $\omega_1$ direction when the sample S is not inclined and when the sample S is inclined by $\varphi$. As illustrated in Fig. 13, the inclination $\varphi$ of the sample S can be estimated from the deviation ($\pi\varphi \cdot Q_p$) of the peak position of the absolute value of G(k, $Q_p$) in the $\omega_1$ direction, and the thickness t of the sample S can be estimated from the peak width ($2\pi/t$) of the absolute value of G(k, $Q_p$) in the $\omega_1$ direction.

Fig. 14 illustrates examples of the argument of G(k, $Q_p$). The arguments at DO1 and DO2 of G(k, $Q_p$) in Equation (2) are given by Equation (13) and Equation (14), respectively.
[Math. 13]

$$\arg G(\boldsymbol{k},\boldsymbol{Q_p})_{DO1} = \chi(\boldsymbol{k}) - \chi(\boldsymbol{k}-\boldsymbol{Q_p}) + \angle V(\boldsymbol{Q_p}) + \frac{\pi}{2} + \arg(\mathrm{sinc}(\omega_1 t)) \quad \cdots(13)$$

[Math. 14]

$$\arg G(\boldsymbol{k},\boldsymbol{Q_p})_{DO2} = -\chi(\boldsymbol{k}) + \chi(\boldsymbol{k}+\boldsymbol{Q_p}) + \angle V(\boldsymbol{Q_p}) - \frac{\pi}{2} + \arg(\mathrm{sinc}(\omega_2 t)) \quad \cdots(14)$$

The argument changes due to the influence of the sinc function of G(k, $Q_p$). The aberration coefficient $C_{n,m}$ can be obtained by fitting the aberration function shown in Equation (7) to the argument data of G(k, $Q_p$). In actual fitting, a plurality of spatial frequencies $Q_p$ are used. In this way, the aberration of the optical system can be estimated.

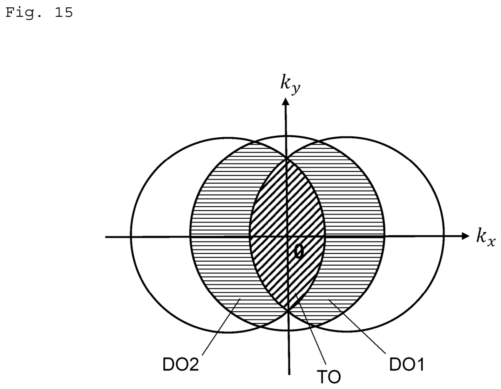

In this way, the observation condition of the sample can be estimated from the amplitude (absolute value) and the phase (argument) of G(k, $Q_p$) at DO1 and DO2. Depending on the value of the spatial frequency $Q_p$, as illustrated in Fig. 15, a triple overlap region in which three disks corresponding to the lens transfer functions T(k), T(k - $Q_p$), and T(k + $Q_p$) overlap on the detector plane is generated. Hereinafter, the triple overlap region is denoted by TO. The argument of G(k, $Q_p$) in TO in Equation (2) is given by Equation (15).
[Math. 15]

$$\arg G(\boldsymbol{k},\boldsymbol{Q_p})_{\mathrm{TO}}$$

$$= \arg\left[\mathrm{sinc}(\omega_1 t)\cdot T^*(\boldsymbol{k})T(\boldsymbol{k}-\boldsymbol{Q_p}) - \mathrm{sinc}(\omega_2 t)\cdot T(\boldsymbol{k})T^*(\boldsymbol{k}+\boldsymbol{Q_p})\right] + \angle V(\boldsymbol{Q_p}) + \frac{\pi}{2} \quad \cdots(15)$$

The aberration coefficient $C_{n,m}$ can be obtained by fitting the aberration function illustrated in Equation (7) to the argument data of G(k, $Q_p$) using Equation (15).

Regarding the amplitude (absolute value) of G(k, $Q_p$), if interference occurs between the first term and the second term on the right side of Equation (2), the thickness t and the inclination $\varphi$ of the sample S cannot be simply estimated. In TO, the first term and the second term interfere with each other, but when the thickness t of the sample S is sufficiently large, sin($\omega_1$t)/$\omega_1$t and sin($\omega_2$t)/$\omega_2$t in Equation (2) rapidly attenuate, so that the interference can be ignored. Therefore, the amplitude of G(k, $Q_p$) in TO when the sample S is sufficiently thick can be approximated as in Equation (16).
[Math. 16]

$$\left|G\left(\boldsymbol{k},\boldsymbol{Q_p}\right)\right| \propto \left|\frac{\sin(\omega_1 t)}{\omega_1 t}\right| + \left|\frac{\sin(\omega_2 t)}{\omega_2 t}\right| \quad \cdots (16)$$

The thickness t and the inclination φ of the sample S can be estimated from the amplitude of $G(k, Q_p)$ in TO by the same method as in the case of using DO1 and DO2.

Next, a method of estimating the aberration of the optical system using an amorphous sample will be described. For the crystalline sample (single crystal, polycrystal), as described above, the argument can be obtained from the two-dimensional profile of the phase of $G(k, Q_p)$ as illustrated in Equations (13) to (15). Meanwhile, for the amorphous sample, as described below, the argument can be obtained by analogy from the theory for the crystalline sample.

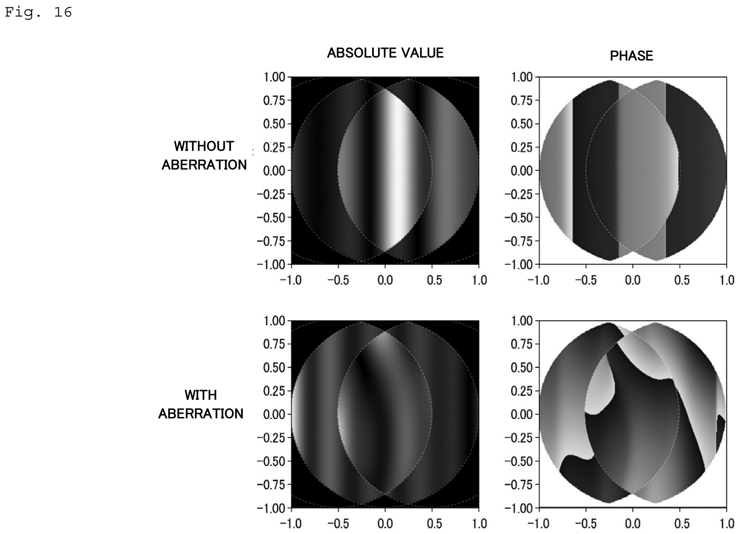

Fig. 16 illustrates examples of simulation results of the absolute value and the phase of $G(k, Q_p)$ obtained when the aberration of the optical system is absent and when the aberration is present at the time of observing the amorphous sample, respectively. As illustrated in Fig. 16, when the aberration is absent, as in the case of the crystalline sample (see Fig. 8), the phase of $G(k, Q_p)$ takes a constant value in a vertical direction. Here, the vertical direction is a direction perpendicular to the spatial frequency vector $Q_p$ (direction in which the scattering disk deviates with respect to the transmission disk), and is a $k_y$ direction in Fig. 15.

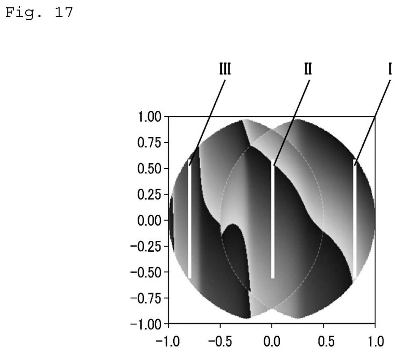

Meanwhile, when the aberration is present, it can be seen that the phase of $G(k, Q_p)$ is modulated in the vertical direction. Therefore, the aberration may be estimated from the phase modulation in the vertical direction. Therefore, a one-dimensional profile in the vertical direction is extracted for each region from the two-dimensional profile of the phase of $G(k, Q_p)$. Specifically, as illustrated in Fig. 17, one-dimensional profiles I, II, and III in the vertical direction having a narrow line width are extracted from DO1, TO, and DO2, respectively. The arguments in the one-dimensional profiles I, II, and III can be expressed as Equation (17), Equation (18), and Equation (19), respectively.

[Math. 17]

$$\arg G\left(\boldsymbol{k},\boldsymbol{Q_p}\right)_{DO1} = \chi(\boldsymbol{k}) - \chi\left(\boldsymbol{k} - \boldsymbol{Q_p}\right) + \text{rand. const.} \quad \cdots (17)$$

[Math. 18]

$$\arg G\left(\boldsymbol{k},\boldsymbol{Q_p}\right)_{\text{TO}} = \angle\left[T^*(\boldsymbol{k})T\left(\boldsymbol{k} - \boldsymbol{Q_p}\right) - T(\boldsymbol{k})T^*\left(\boldsymbol{k} + \boldsymbol{Q_p}\right)\right] + \text{rand. const.} \quad \cdots (18)$$

[Math. 19]

$$\arg G\left(\boldsymbol{k},\boldsymbol{Q_p}\right)_{DO2} = -\chi(\boldsymbol{k}) + \chi\left(\boldsymbol{k} + \boldsymbol{Q_p}\right) + \text{rand. const.} \quad \cdots (19)$$

Equation (17), Equation (18), and Equation (19) are derived by analogy from Equation (13), Equation (15), and Equation (14), respectively. Here, the rand. const. in each Equation is a random offset value that differs depending on the position where the one-dimensional profile is extracted. The aberration coefficient $C_{n,m}$ can be obtained by fitting the aberration function illustrated in Equation (7) to the argument data of $G(k, Q_p)$ using Equations (17) to (19). However, in Equation (18), the phase may be shifted by π on the one-dimensional profile, but since the position of the phase shift changes due to defocus, fitting is performed in consideration of this.

For the crystalline sample, similarly to the amorphous sample, the argument can be obtained by extracting the one-dimensional profile of the phase of $G(k, Q_p)$ for each region, but more robust estimation can be performed by obtaining the argument using the two-dimensional profile.

According to the measurement method using the scanning transmission electron microscope according to the present embodiment, the observation condition can be estimated from the four-dimensional dataset acquired by the detector 106 without assuming the ideal observation condition as in the conventional art.

By reconstructing the sample image using the estimated observation condition, the structure of the sample S can be clearly visualized even if the adjustment of the observation conditions is insufficient. As a method for reconstructing the sample image, an OBF method or other ptychography can be used.

Further, by feeding back the sample inclination estimation result and the aberration estimation result to an inclination correction device and an aberration correction device, respectively, and correcting the sample inclination and the aberration, it is possible to observe the sample S under more ideal conditions. For example, the technique disclosed in JP2012-22971A can be used as the aberration correction method.

The present invention is not limited to the embodiment described above, and various modifications can be made without departing from the gist of the present invention.

Reference Sign List

100    scanning transmission electron microscope system
102    irradiation source
104    lens
106    detector
108    computer
202    processor
204    display
206    storage device
208    main memory
210    input device
212    communication interface
EB    electron beam
S    sample
Oz    optical axis

**Claims**

1. A measurement method of an observation condition of a sample using a scanning transmission electron microscope, the measurement method comprising:

generating an electron beam by an irradiation source;
converging the electron beam generated by the irradiation source onto the sample by an optical system;
detecting, by a detector, the electron beam transmitted through the sample, and acquiring a detection signal which is a four-dimensional dataset represented by a two-dimensional scanning position on the sample and two-dimensional coordinates on a detector plane; and
causing a computer to

perform a Fourier transform on the detection signal acquired by the detector with respect to the scanning position to obtain Fourier transform data of a complex number represented by a two-dimensional spatial frequency and the two-dimensional coordinates, and
calculate, for a specific spatial frequency, a thickness of the sample and an inclination of the sample with respect to a predetermined direction from an amplitude of the Fourier transform data when the sample is a crystalline sample; and calculate, for a specific spatial frequency, an aberration of the optical system from a phase of the Fourier transform data when the sample is a crystalline sample or an amorphous sample.

2. The measurement method according to claim 1, wherein
the thickness of the sample is calculated from a peak width of the amplitude.

3. The measurement method according to claim 1, wherein
the inclination of the sample is calculated from a peak position of the amplitude.

4. The measurement method according to claim 1, wherein
the Fourier transform data is obtained using a weak phase object approximation considering the thickness of the sample.

5. The measurement method according to claim 1, wherein

the Fourier transform data is obtained using a lens transfer function representing a characteristic of the optical system,
the thickness and the inclination of the sample are calculated from the amplitude of the Fourier transform data in a double overlap region where two of three disks represented by the lens transfer function overlap on the detector plane, and
the aberration of the optical system is calculated from the phase of the Fourier transform data in the double overlap region.

6. The measurement method according to claim 1, wherein

the Fourier transform data is obtained using a lens transfer function representing a characteristic of the optical system,
the thickness and the inclination of the sample are calculated from the amplitude of the Fourier transform data in a triple overlap region where three disks represented by the lens transfer function overlap on the detector plane, and
the aberration of the optical system is calculated from the phase of the Fourier transform data in the triple overlap region.

7. The measurement method according to claim 1, wherein
when the sample is a crystalline sample, the aberration of the optical system is calculated using a two-dimensional profile of the phase of the Fourier transform data.

8. The measurement method according to claim 1, wherein
when the sample is a crystalline sample or the amorphous sample, the aberration of the optical system is calculated using a one-dimensional profile of the phase of the Fourier transform data.

9. A scanning transmission electron microscope system for measuring an observation condition of a sample, the scanning transmission electron microscope system comprising:

an irradiation source configured to generate an electron beam;
an optical system configured to converge the electron beam generated by the irradiation source onto the sample;
a detector configured to detect the electron beam transmitted through the sample, and acquire a detection signal which is a four-dimensional dataset represented by a two-dimensional scanning position on the sample and two-dimensional coordinates on a detector plane; and
a computer configured to

perform a Fourier transform on the detection signal acquired by the detector with respect to the scanning position to obtain Fourier transform data of a complex number represented by a two-dimensional spatial frequency and the two-dimensional coordinates,
calculate, for a specific spatial frequency, a thickness of the sample and an inclination of the sample with respect to a predetermined direction from an amplitude of the Fourier transform data when the sample is a crystalline sample; and calculate, for a specific spatial frequency, an aberration of the optical system from a phase of the Fourier transform data when the sample is a crystalline sample or an amorphous sample.

10. A program for estimating an observation condition of a sample using a scanning transmission electron microscope, the program causing a computer to execute:

acquiring, from a detector that detects an electron beam transmitted through the sample, a detection signal which is a four-dimensional dataset represented by a two-dimensional scanning position on the sample and two-dimensional coordinates on a detector plane, and performing a Fourier transform on the detection signal with respect to the scanning position to obtain Fourier transform data of a complex number represented by a two-dimensional spatial frequency and the two-dimensional coordinates; and
calculating, for a specific spatial frequency, a thickness of the sample and an inclination of the sample with respect to a predetermined direction from an amplitude of the Fourier transform data when the sample is a crystalline sample; and calculating, for a specific spatial frequency, an aberration of an optical system of the scanning transmission electron microscope from a phase of the Fourier transform data when the sample is a crystalline sample or an amorphous sample.

Fig. 1

Fig. 2

108

| PROCESSOR 202 | DISPLAY 204 |
| STORAGE DEVICE 206 | MAIN MEMORY 208 |
| INPUT DEVICE 210 | COMMUNICATION INTERFACE 212 |

Fig. 3

Fig. 4

$$k = \frac{\theta}{\lambda}$$

Fig. 5

Fig. 6

SAMPLE IS THIN  SAMPLE IS THICK

Fig. 7

SAMPLE IS NOT INCLINED  SAMPLE IS INCLINED

Fig. 8

WITHOUT ABERRATION  WITH ABERRATION

Fig. 9

Fig. 10

Fig. 11

$$\boldsymbol{\phi} = (\phi_x, \phi_y)$$

Fig. 12

Fig. 13

$\pi\boldsymbol{\phi} \cdot \boldsymbol{Q_p}$

Amplitude

$\omega_1$

$$\frac{2\pi}{t}$$

——— SAMPLE IS NOT INCLINED

----- SAMPLE IS INCLINED

Fig. 14

$\arg G(\boldsymbol{k}, \boldsymbol{Q_p})_{DO2}$ $\quad$ $\arg G(\boldsymbol{k}, \boldsymbol{Q_p})_{DO1}$

$k_y [\text{Å}^{-1}]$

$k_x [\text{Å}^{-1}]$

DO2 $\qquad$ DO1

Fig. 15

Fig. 16

ABSOLUTE VALUE          PHASE

WITHOUT ABERRATION

WITH ABERRATION

Fig. 17

# EP 4 734 149 A1

<table>
<tr><td colspan="2"><strong>INTERNATIONAL SEARCH REPORT</strong></td><td>International application No.<br><br><strong>PCT/JP2024/022523</strong></td></tr>
</table>

**A.    CLASSIFICATION OF SUBJECT MATTER**

*H01J 37/28*(2006.01)i; *G01N 23/04*(2018.01)i
FI:    H01J37/28 C; G01N23/04 330

According to International Patent Classification (IPC) or to both national classification and IPC

**B.    FIELDS SEARCHED**

Minimum documentation searched (classification system followed by classification symbols)

H01J37/00-37/36; G01N23/00-23/2276

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus (JDreamIII)

**C.    DOCUMENTS CONSIDERED TO BE RELEVANT**

| Category* | Citation of document, with indication, where appropriate, of the relevant passages | Relevant to claim No. |
|---|---|---|
| A | JP 2021-077523 A (THE UNIVERSITY OF TOKYO) 20 May 2021 (2021-05-20)<br>abstract, fig. 1 | 1-10 |
| A | JP 2015-032384 A (HITACHI HIGH-TECHNOLOGIES CORPORATION) 16 February 2015 (2015-02-16)<br>abstract, fig. 7 | 1-10 |
| A | JP 2018-195545 A (JEOL LTD.) 06 December 2018 (2018-12-06)<br>abstract, fig. 2 | 1-10 |
| A | JP 2009-002748 A (FUJITSU LIMITED) 08 January 2009 (2009-01-08)<br>paragraphs [0093]-[0100], fig. 17 | 1-10 |

☐ Further documents are listed in the continuation of Box C.          ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **22 July 2024** | **06 August 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/022523**

| Patent document cited in search report | | | Publication date (day/month/year) | Patent family member(s) | | | Publication date (day/month/year) |
|---|---|---|---|---|---|---|---|
| JP | 2021-077523 | A | 20 May 2021 | US | 2023/0040811 | A1 | |
| | | | | abstract, fig. 1 | | | |
| | | | | WO | 2021/090528 | A1 | |
| | | | | EP | 4057320 | A1 | |
| JP | 2015-032384 | A | 16 February 2015 | WO | 2015/015985 | A1 | |
| | | | | abstract, fig. 7 | | | |
| JP | 2018-195545 | A | 06 December 2018 | (Family: none) | | | |
| JP | 2009-002748 | A | 08 January 2009 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021090528 A

- JP 2012022971 A

**Non-patent literature cited in the description**

- **KOUSUKE OOE** ; **TAKEHITO SEKI** ; **YUICHI IKUHARA** ; **NAOYA SHIBATA**. Ultra-high contrast STEM imaging for segmented/pixelated detectors by maximizing the signal-to-noise ratio. *Ultramicroscopy*, 2021, vol. 220, 113133
- **EARL J. KIRKLAND**. Advanced Computing in Electron Microscopy. Springer

- **H. SAWADA** ; **T. SANNOMIYA** ; **F. HOSOKAWA** ; **T. NAKAMICHI** ; **T. KANEYAMA** ; **T. TOMITA** ; **Y. KONDO** ; **T. TANAKA** ; **Y. OSHIMA** ; **Y. TANISHIRO**. Measurement method of aberration from Ronchigram by autocorrelation function. *Ultramicroscopy*, 2008, vol. 108, 1467-1475